# EUROPEAN PATENT APPLICATION

(11) **EP 4 723 822 A1**
(43) Date of publication of application: **08.04.2026**
(21) Application number: 24814917.1
(22) Date of filing: 07.03.2024
(51) Int. Cl.: H05K 9/00, B22F 1/05, H01F 1/20

(54) **NOISE SUPPRESSION MEMBER**

(30) Priority: 31.05.2023 JP 2023090036
(71) Applicant: Kitagawa Industries Co., Ltd., Inazawa-shi, Aichi 492-8446 (JP)
(72) Inventor: ISHIHARA, Taichi, Kasugai-shi, Aichi 480-0303 (JP)
(74) Representative: Meissner Bolte Partnerschaft mbB
(86) International application number: PCT/JP2024/008861
(87) International publication number: WO 2024/247430

(57) **Abstract**

[Object] To provide a noise suppression member in which a blending amount of flaky magnetic powder is greater than that in the product of the related art, and in which excellent magnetic properties are exhibited. [Solution] The noise suppression member includes a composite composition containing the flaky magnetic powder and a binder. A content ratio of the flaky magnetic powder is from 88.9 mass% to 90 mass% in terms of a mass ratio with respect to 100 mass% of the composite composition. The binder contains hydrogenated nitrile rubber and polyolefin. A content ratio of the hydrogenated nitrile rubber is from 2 mass% to 9 mass% in terms of the mass ratio with respect to 100 mass% of the composite composition. A content ratio of the polyolefin is from 1 mass% to 8 mass% in terms of the mass ratio with respect to 100 mass% of the composite composition.

## Description

### Technical Field

The present disclosure relates to a noise suppression member.

### Background Art

A composite magnetic sheet including an organic binder and flaky magnetic powder dispersed in the organic binder has been proposed (see, for example, Patent Document 1). According to Patent Document 1 described below, suppression of noise at frequencies exceeding the UHF band, for example, 5 GHz, can be achieved by using the composite magnetic sheet described in Patent Document 1.

### Citation List

### Patent Literature

Patent Document 1: JP 6405355 B

### Summary of Invention

### Technical Problem

In the composite magnetic sheet disclosed in the above Patent Document 1, a volume occupancy ratio of the flaky magnetic powder in the composite magnetic sheet is not less than 40 vol% and not more than 50 vol%, and preferably, not less than 45 vol% and not more than 50 vol%. In the composite magnetic sheet of the above Patent Document 1, when the volume occupancy ratio exceeds 50 vol%, the film quality of the composite magnetic sheet deteriorates, the flexibility decreases, the sheet surface resistivity decreases, and the like, and thus the volume occupancy ratio is defined to be not more than 50 vol%.

However, it has been found through further study by the present inventors that, by selecting a specific binder, an amount of magnetic powder exceeding 50 vol% can be blended without impairing the physical properties or processability as a sheet material. Moreover, it has been found that, in a range in which a blending amount of magnetic powder exceeds 50 vol%, there exists a numerical range in which magnetic properties are specifically improved, compared with a case in which the blending amount of magnetic powder is not more than 50 vol%. The technique described below is a technique that has been completed based on the above findings.

An aspect of the present disclosure is to provide a noise suppression member in which a blending amount of flaky magnetic powder is greater than that in the product of the related art and excellent magnetic properties are exhibited.

### Solution to Problem

Configurations of the present disclosure will be described below.

(1) One aspect of the present disclosure is a noise suppression member including a composite composition containing flaky magnetic powder and a binder. The flaky magnetic powder is one alloy powder or a mixture of two or more alloy powders selected from among an Fe-Si-Cr alloy, an Fe-Si alloy, and an Fe-Cr alloy. A median diameter of the flaky magnetic powder is from 10 µm to 30 µm. A content ratio of the flaky magnetic powder is from 88.9 mass% to 90 mass% in terms of a mass ratio with respect to 100 mass% of the composite composition. The binder contains hydrogenated nitrile rubber and polyolefin. A content ratio of the hydrogenated nitrile rubber is from 2 mass% to 9 mass% in terms of a mass ratio with respect to 100 mass% of the composite composition. A content ratio of the polyolefin is from 1 mass% to 8 mass% in terms of the mass ratio with respect to 100 mass% of the composite composition.

In the noise suppression member, when a content ratio of the flaky magnetic powder is adjusted to be within a range from 88.9 mass% to 90 mass%, the magnetic permeability of the noise suppression member is specifically improved, as exemplified in examples in an embodiment described below. In addition, by setting the content ratio of the hydrogenated nitrile rubber to not less than 2 mass%, the tensile strength of the sheet required in the manufacturing process can be obtained. By setting the content ratio of the hydrogenated nitrile rubber to not more than 9 mass%, the occurrence of strong repulsion in a sheeting process and a rolling process can be suppressed, and the sheet can be stretched to an appropriate thickness.

Furthermore, in the noise suppression member, by setting the content ratio of the polyolefin to not less than 1 mass%, the occurrence of strong repulsion in the sheeting process and the rolling process can be suppressed, and the sheet can be stretched to an appropriate thickness. In addition, in the noise suppression member, by setting the content ratio of the polyolefin to not more than 8 mass%, the occurrence of adhesion of the sheet to a roll during heated rolling can be suppressed, and the production of the sheet can be stabilized.

According to the noise suppression member configured in this manner, the noise suppression member includes the composite composition containing the flaky magnetic powder and the binder, and the binder contains the hydrogenated nitrile rubber and the polyolefin blended at the composition ratio as described above. Therefore, unlike the related art in which the volume occupancy ratio of the magnetic powder has been required to be not more than 50 vol%, the magnetic powder can be blended in the above composite composition in an amount exceeding 50 vol%.

More specifically, in the present disclosure, as the flaky magnetic powder, one alloy powder or a mixture of two or more alloy powders selected from among an Fe-Si-Cr alloy, an Fe-Si alloy, and an Fe-Cr alloy is used. A median diameter of the flaky magnetic powder is from 10 µm to 30 µm. The content ratio of the flaky magnetic powder is set to 88.9 mass% to 90 mass% in terms of the mass ratio with respect to 100 mass% of the composite composition.

This mass ratio of 88.9 mass% to 90 mass% corresponds to 52.5 vol% to 54.5 vol% when converted into a volume occupancy ratio in the case of the present disclosure. That is, the composite composition constituting the above noise suppression member contains the magnetic powder in an amount exceeding 50 vol%. However, as described above, since the binder contains the hydrogenated nitrile rubber and the polyolefin blended at the composition ratio as described above, deterioration in the physical properties and the processability as a sheet material can be suppressed even in a case in which the above composite composition is processed into a sheet form.

In addition, in the noise suppression member, by adjusting a content ratio of the flaky magnetic powder to fall within the above range of 88.9 mass% to 90 mass%, a noise suppression member that exhibits high magnetic permeability in a high-frequency band of 3 GHz to 6 GHz can be formed. The relationship between the content ratio of the flaky magnetic powder and the magnetic permeability will be described in detail in the embodiment described below.

Note that the present disclosure may include the following configurations.

(2) In one aspect of the present disclosure, a content ratio of the flaky magnetic powder may be 89.2 mass% to 89.5 mass% in terms of the mass ratio with respect to 100 mass% of the composite composition.

By adopting such a configuration, the noise suppression member can be configured in which the magnetic permeability is particularly high in a high-frequency band of 3 GHz to 6 GHz.

(3) In one aspect of the present disclosure, the noise suppression member may be sheet-shaped having a thickness of 0.3 mm to 0.5 mm.

(4) In one aspect of the present disclosure, complex magnetic permeability µ' (real part) in a frequency band of 3 GHz to 6 GHz may be not less than 1.

(5) In one aspect of the present disclosure, a surface resistance value may be not less than 1 × 10⁶ Ω/□ (Ω/sq).

### Brief Description of Drawings

FIG. 1 is a graph illustrating a relationship between content ratios of flaky magnetic powder and measured values of complex magnetic permeability µ' (real part) of a noise suppression member at a frequency of 6 GHz.
FIG. 2 is a graph illustrating measured values of the complex magnetic permeability µ' (real part) and complex magnetic permeability µ" (imaginary part) of the noise suppression member in a frequency band of 0.1 GHz to 6 GHz.

### Description of Embodiments

Next, the noise suppression member described above will be described with reference to an exemplary embodiment.

### Production Example of Noise Suppression Member

Noise suppression members (Specimen 1 to Specimen 7) are produced according to the procedure described below.

First, hydrogenated nitrile rubber, polyolefin, and a lubricant are weighed in mass ratios shown in Table 1, and then kneaded using a kneader to prepare a binder composition. Subsequently, the flaky magnetic powder is weighed in a mass ratio shown in Table 1, and the flaky magnetic powder and the above binder composition are kneaded using a kneader. When the flaky magnetic powder and the binder composition are kneaded, each material is heated in advance and kneading is performed under a temperature condition of 70°C to 90°C.

The flaky magnetic powder is one alloy powder or a mixture of two or more alloy powders selected from among an Fe-Si-Cr alloy, an Fe-Si alloy, and an Fe-Cr alloy. The median diameter of the flaky magnetic powder is from 10 µm to 30 µm. An aspect ratio of the flaky magnetic powder is from 10 to 40. Note that the aspect ratio in the present embodiment refers to a value obtained by dividing a dimension in a major axis direction of the flaky magnetic powder by a dimension in a thickness direction of the flaky magnetic powder.

Subsequently, since the material kneaded by the kneader contains a portion that have formed lumps, the material is pulverized so that the particles contained in the material have approximately the same size. Subsequently, sheeting is performed with a sheeting roll heated to approximately 40°C to 60°C. Subsequently, the material after sheeting is rolled by a rolling roll heated to approximately 40°C to 60°C to form a sheet having a thickness of approximately 0.3 mm to 0.5 mm.

Subsequently, the rolled sheet is cut into strips and subjected to vacuum pressing at 150°C for 5 minutes. This vacuum pressing can promote degassing from the sheet to increase the sheet density and also promote crosslinking within the material.

**[Table 1]**

| Specimen No. | | 1 | 2 | 3 | 4 | 5 | 6 | 7 |
|---|---|---|---|---|---|---|---|---|
| Flaky magnetic powder (mass%) | | 85.0 | 88.7 | 88.9 | 89.2 | 89.5 | 90.0 | 90.3 |
| Binder | Hydrogenated nitrile rubber (mass%) | 6.7 | 5.0 | 4.9 | 4.8 | 4.7 | 4.4 | 4.3 |
| | Polyolefin (mass%) | 5.6 | 4.2 | 4.1 | 4.0 | 3.9 | 3.7 | 3.6 |
| | Lubricant (mass%) | 2.8 | 2.1 | 2.1 | 2.0 | 1.9 | 1.9 | 1.8 |
| Remarks | | Comparative Example | Comparative Example | Examples | Examples | Examples | Examples | Comparative Example |

### Performance Test

The following performance tests were performed for Specimen 1 to Specimen 7 described above.

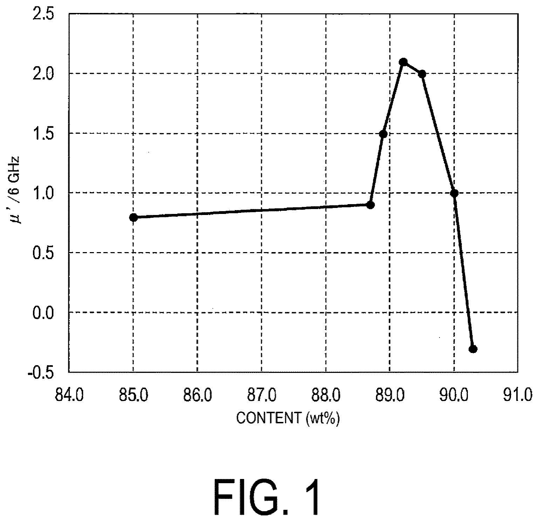

Complex magnetic permeability was measured with the above Specimen 1 to Specimen 7 as measurement targets. In the measurement, a commercially available RF impedance analyzer (manufactured by Agilent Technologies, Inc., Model E4991A) was used. In performing the measurement, a ring-shaped measurement specimen having an outer diameter of 18 mm and an inner diameter of 6 mm was cut out from each specimen, and the measurement was performed. As a measurement condition for measuring the complex magnetic permeability, the measurement frequency was set to 0.1 GHz to 6 GHz. A relationship between content ratios of the flaky magnetic powder and measured values of the complex magnetic permeability µ' (real part) of the noise suppression member at a frequency 6 GHz is illustrated in FIG. 1 and shown in Table 2.

**[Table 2]**

| Specimen No. | 1 | 2 | 3 | 4 | 5 | 6 | 7 |
|---|---|---|---|---|---|---|---|
| µ'/6 GHz | 0.8 | 0.9 | 1.5 | 2.1 | 2.0 | 1.0 | -0.3 |
| Remarks | Comparative Example | Comparative Example | Examples | Examples | Examples | Examples | Comparative Example |

The measurement results illustrated in FIG. 1 and shown in Table 2 suggested that Specimen 3 to Specimen 6 had values of the complex magnetic permeability µ' (real part) not less than 1 and were effective as the noise countermeasure members. In particular, Specimen 4 and Specimen 5 had values of the complex magnetic permeability µ' (real part) not less than 2, and were suggested to have excellent noise countermeasure performance. Specimen 3 to Specimen 6 are specimens having the content of the flaky magnetic powder is in a mass ratio of 88.9 mass% to 90 mass%, and corresponding to 52.5 vol% to 54.5 vol% when converted into a volume occupancy ratio.

That is, the composite composition constituting the above Specimen 3 to Specimen 6 contains more than 50 vol% of the flaky magnetic powder. However, as described above, since the binder contains the hydrogenated nitrile rubber and the polyolefin blended at the composition ratio as described above, deterioration in the physical properties and the processability as a sheet material can be suppressed even in a case in which the above composite composition is processed into a sheet form.

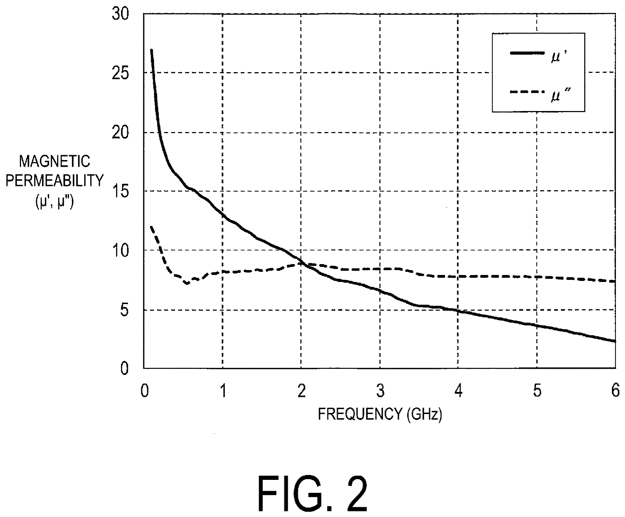

Next, in the above tests, for Specimen 4 having the highest value of the complex magnetic permeability µ' (real part), measured values of the complex magnetic permeability µ' (real part) and the complex magnetic permeability µ" (imaginary part) of the noise suppression member in a frequency band of 0.1 GHz to 6 GHz are illustrated in FIG. 2. From FIG. 2, it was suggested that the complex magnetic permeability µ' (real part) of Specimen 4 remained not less than 1 in a frequency band of 3 GHz to 6 GHz, and was effective for noise countermeasures up to 6 GHz.

Next, for Specimen 4 described above, the surface resistance value was measured in accordance with JIS K 6911. For the measurement, a commercially available surface resistivity meter (manufactured by Mitsubishi Chemical Corporation, trade name: Hiresta-UP MCP-HT450) was used. During the measurement, a probe (electrode) was pressed against the surface of the specimen, and the surface resistance value was measured based on a current value flowing on the surface. The surface resistance value of Specimen 4 was 6 × 10⁶ Ω/□.

### Beneficial Effects

As described above, in the above noise suppression member, the magnetic powder in an amount exceeding 50 vol% can be blended in the composite composition constituting the noise suppression member. Moreover, since the binder contains the hydrogenated nitrile rubber and the polyolefin blended at the above-described composition ratio, deterioration in physical properties and processability as a sheet material can be suppressed even in a case in which the above composite composition is processed into a sheet form.

In addition, since the content ratio of the flaky magnetic powder is adjusted within the range of 88.9 mass% to 90 mass%, a noise suppression member exhibiting the high magnetic permeability in a high-frequency band of 3 GHz to 6 GHz can be configured.

### Other Embodiments

As described above, although the noise suppression member has been described with reference to the exemplary embodiment, the above-described embodiment is merely an example presented as an aspect of the present disclosure. That is, the present disclosure is not limited to the exemplary embodiments described above, and can be carried out in various forms without departing from the technical concept of the present disclosure.

### Technical Concept Disclosed in Specification

### [Item 1]

A noise suppression member including:
a composite composition containing flaky magnetic powder and a binder,
in which the flaky magnetic powder is one alloy powder or a mixture of two or more alloy powders selected from among an Fe-Si-Cr alloy, an Fe-Si alloy, and an Fe-Cr alloy,
the flaky magnetic powder has a median diameter of 10 µm to 30 µm,
a content ratio of the flaky magnetic powder is from 88.9 mass% to 90 mass% in terms of a mass ratio with respect to 100 mass% of the composite composition,
the binder contains hydrogenated nitrile rubber and polyolefin,
a content ratio of the hydrogenated nitrile rubber is from 2 mass% to 9 mass% in terms of the mass ratio with respect to 100 mass% of the composite composition,
and a content ratio of the polyolefin is from 1 mass% to 8 mass% in terms of the mass ratio with respect to 100 mass% of the composite composition.

### [Item 2]

The noise suppression member according to item 1, in which the content ratio of the flaky magnetic powder is from 89.2 mass% to 89.5 mass% in terms of the mass ratio with respect to 100 mass% of the composite composition.

### [Item 3]

The noise suppression member according to item 1 or 2, in which the noise suppression member is sheet-shaped having a thickness of 0.3 mm to 0.5 mm.

### [Item 4]

The noise suppression member according to any items from 1 to 3, in which complex magnetic permeability µ' (real part) in a frequency band of 3 GHz to 6 GHz is not less than 1.

### [Item 5]

The noise suppression member according to any items from 1 to 4, in which a surface resistance value is not less than 1 × 10⁶ Ω/□.

## Claims

1. A noise suppression member comprising:
a composite composition containing flaky magnetic powder and a binder,
wherein the flaky magnetic powder is one alloy powder or a mixture of two or more alloy powders selected from among an Fe-Si-Cr alloy, an Fe-Si alloy, and an Fe-Cr alloy,
the flaky magnetic powder has a median diameter of 10 µm to 30 µm,
a content ratio of the flaky magnetic powder is from 88.9 mass% to 90 mass% in terms of a mass ratio with respect to 100 mass% of the composite composition,
the binder contains hydrogenated nitrile rubber and polyolefin,
a content ratio of the hydrogenated nitrile rubber is from 2 mass% to 9 mass% in terms of the mass ratio with respect to 100 mass% of the composite composition, and
a content ratio of the polyolefin is from 1 mass% to 8 mass% in terms of the mass ratio with respect to 100 mass% of the composite composition.

2. The noise suppression member according to claim 1,
wherein the content ratio of the flaky magnetic powder is from 89.2 mass% to 89.5 mass% in terms of the mass ratio with respect to 100 mass% of the composite composition.

3. The noise suppression member according to claim 1 or 2,
wherein the noise suppression member is sheet-shaped having a thickness of 0.3 mm to 0.5 mm.

4. The noise suppression member according to claim 1 or 2,
wherein complex magnetic permeability µ' (real part) in a frequency band of 3 GHz to 6 GHz is not less than 1.

5. The noise suppression member according to claim 1 or 2,
wherein a surface resistance value is not less than 1 × 10⁶ Ω/□.
